(19) Europäisches Patentamt
European Patent Office
Office européen des brevets

(11) **EP 3 329 287 B1**

(12) **EUROPEAN PATENT SPECIFICATION**

(45) Date of publication and mention
of the grant of the patent:
**20.04.2022  Bulletin 2022/16**

(21) Application number: **15899844.3**

(22) Date of filing: **29.07.2015**

(51) International Patent Classification (IPC):
*G01R 19/165* (2006.01)    *G01R 23/165* (2006.01)
*G01R 31/42* (2006.01)    *G01R 31/317* (2006.01)
*G05F 1/10* (2006.01)

(52) Cooperative Patent Classification (CPC):
**G01R 31/42**

(86) International application number:
**PCT/US2015/042593**

(87) International publication number:
**WO 2017/019053 (02.02.2017 Gazette 2017/05)**

(54) **HIGH FREQUENCY VOLTAGE SUPPLY MONITOR**

HOCHFREQUENZSPANNUNGSVERSORGUNGSMONITOR

DISPOSITIF DE SURVEILLANCE D'ALIMENTATION EN TENSION ÉLECTRIQUE HAUTE FRÉQUENCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.06.2018  Bulletin 2018/23**

(73) Proprietor: **Ampere Computing LLC
Santa Clara, California 95054 (US)**

(72) Inventors:
• **RAVEZZI, Luca
San Francisco, California 94110 (US)**

• **HARVARD, Qawi
San Jose, California 95126 (US)**
• **PARTOVI, Hamid
Los Altos, California 94024 (US)**

(74) Representative: **Papula Oy
P.O. Box 981
00101 Helsinki (FI)**

(56) References cited:
JP-A- H03 158 768    US-A- 4 795 971
US-A1- 2006 214 672    US-A1- 2007 188 947
US-A1- 2010 085 110    US-A1- 2010 214 711
US-A1- 2011 096 891    US-B1- 7 436 216

## Description

TECHNICAL FIELD

This disclosure relates generally to power monitoring in digital systems.

BACKGROUND

Microelectronic systems are often subject to voltage fluctuations on the power supply rails that deliver power to the various integrated circuit (IC) components that make up the systems. Spikes, oscillations, or other such power supply noise may cause unpredictable circuit responses, or otherwise degrade system performance and reliability. Power supply fluctuations become increasingly problematic as the nominal supply voltage of microelectronic circuits decreases, as with circuits using nanometer technologies designed to operate at lower supply voltages relative to older technologies. For example, some circuits using nanometer technologies are designed to operate at a 0.9VDC supply voltage, compared with 5VDC for older systems. As the nominal supply voltage decreases, so does system tolerance to power supply noise.

High frequency digital systems are particularly prone to power supply noise, since sudden changes in the system activity rate may cause spikes, droops, or even temporary oscillations on the voltage supply rails. Power rail spikes and oscillations are also a function of IR drops, or DC voltage drops due to parasitic resistances between the power supply and circuit components. Another source of power supply fluctuations is di/dt noise, or instantaneous voltage variations due to inductive effects on the power lines.

Monitoring the internal supply rail of a microelectronic circuit can be difficult. Although some systems include a monitoring system dedicated to monitoring the internal power supply line, such systems often have limited bandwidth, and consequently can only provide information on relatively low frequency variations on the power supply rails. These monitor systems can be used to compensate for IR and DC drops on the internal supply rails but are inadequate for high frequency noise caused mostly by di/dt fluctuations.

US2010085110 A1 discloses an apparatus for compensating for voltage fluctuations on a voltage supply line in an integrated circuit device. The apparatus includes voltage fluctuation sensor which senses a voltage on the supply line and a compensation circuit comprising a switch and a charge storage device (CSD). The switch actively connects the CSD to the supply line when the voltage sensed by the voltage fluctuation sensor passes outside a predetermined voltage range.

SUMMARY

The invention is set out in the appended claims.

Monitoring and measuring high frequency power supply fluctuations in real time can allow such fluctuations to be compensated for, thereby improving overall system performance. To this end, embodiments of the high frequency voltage supply monitor described herein can sense high frequency variations of an integrated circuit's internal supply voltage, amplify these measured variations, and deliver the resulting amplified signal to output pads for monitoring and measurement. The voltage supply monitor is designed to have a constant gain over a wide bandwidth, and is AC coupled to the power supply rails such that the monitor is sensitive only to high frequency voltage variations.

In embodiments, the voltage supply monitor comprises a differential amplifier circuit designed to have a limited gain, such that offsets in the circuit do not cause the amplifier to saturate, allowing the monitor to accurately detect AC variations of the internal supply voltage under a variety of conditions. The differential amplifier circuit has a well defined gain so that AC variations can be accurately measured and delivered to the specific compensation circuitry. The voltage supply monitor does not require calibration, sampling systems, or analog-to-digital (AD) converters.

BRIEF DESCRIPTION OF THE DRAWINGS

FIG. 1 is a diagram of a microelectronic circuit including a voltage supply monitor for monitoring high frequency variations on the circuit's voltage supply rails.

FIG. 2 illustrates a differential circuit that can be used to perform high frequency voltage monitoring of voltage supply rails.

FIG. 3 illustrates a degenerative differential pair circuit capable of performing high frequency voltage monitoring of voltage supply rails.

FIG. 4 illustrates an example circuit capable of monitoring both high-frequency and low-frequency voltage variations.

FIG. 5 is a diagram of an example microelectronic system that performs real time circuit compensation based on measured voltage variations.

FIG. 6 is a diagram of a system for logging data relating to measured voltage variations on the voltage supply rails of a microelectronic circuit.

FIG. 7 illustrates a flow diagram of an embodiment of monitoring high frequency voltage variations on the supply rails.

FIG. 8 illustrates a flow diagram of an embodiment of recording high frequency voltage variations detected on the supply rails.

FIG. 9 illustrates a flow diagram of an embodiment of compensating for high frequency voltage variations detected on the supply rails.

DETAILED DESCRIPTION

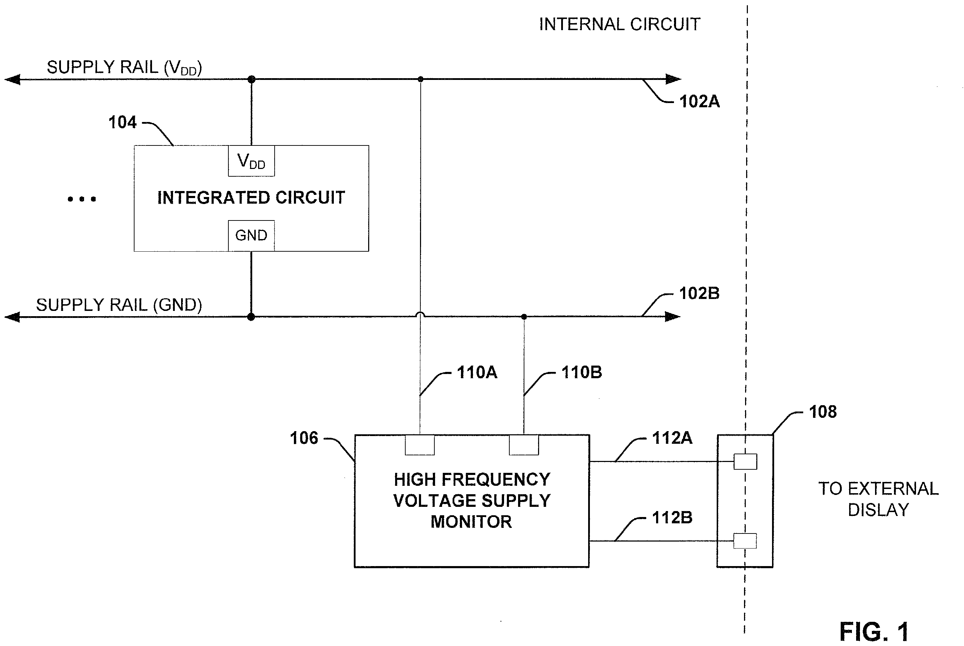

Various aspects of the present disclosure provide a high frequency voltage supply monitor capable of monitoring high frequency variations on the internal power supply rails of an integrated circuit (e.g., a system-on-chip or other microelectronic circuit). **FIG. 1** is a high-level diagram of a microelectronic circuit that includes a voltage supply monitor for monitoring high frequency variations on the circuit's voltage supply rails. The microelectronic circuit can comprise, for example, an integrated circuit (IC), a system of IC chips, a system-on-chip (SoC), or other such microelectronic system. The circuit includes one or more IC components - such as IC chip104 - which receive power via supply rails 102A and 102B.

The voltage on supply rails 102A and 102B may be susceptible to high frequency voltage fluctuations as a result of internal circuit characteristics, including but not limited to IR drop and di/dt noise. Moreover, sudden increases in the activity rate of the IC components 104 fed by supply rails 102A and 102B may cause voltage spikes or oscillations on the supply rails. These voltage variations may cause unpredictable or unreliable performance of the IC components, which may have low tolerances for power supply deviations.

In order to monitor and characterize these high frequency voltage fluctuations, a high frequency voltage supply monitor 106 is included as part of the internal circuit. In some embodiments, voltage supply monitor 106 may be part of the system's internal debug circuit. Input lines 110A and 110B of the high frequency voltage supply monitor 106 are electrically connected to supply rails 102A and 102B to facilitate monitoring and measuring high frequency voltage noise on the rails. Voltage supply monitor 106 detects high frequency voltage variations on supply rails 102A and 102B, amplifies the measured variations, and delivers the amplified measurements as signals to output pads 108 via output lines 112A and 112B or to internal circuitry for further elaboration and/or compensation.

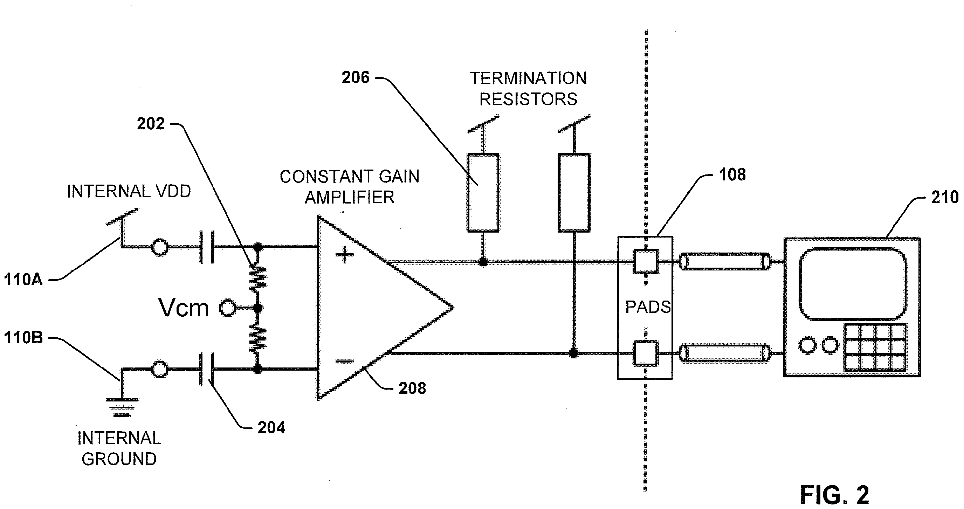

In one or more embodiments, high frequency voltage supply monitor 106 can comprise a differential amplifier circuit characterized by a limited, relatively constant gain over a wide bandwidth, which allows the voltage supply monitor 106 to detect high frequency AC variations of the voltage on supply rails 102A and 102B. **FIG. 2** illustrates a differential circuit that can be used to perform high frequency voltage monitoring of voltage supply rails 102A and 102B. In this embodiment, internal power supply rails 102A and 102B ($V_{DD}$ and ground, respectively) are AC connected to a differential amplifier 208 via capacitances 204 and resistors 202, which form a high-pass RC filter that passes high frequency voltage variations on power supply rails 102A to differential amplifier 208. The high-pass RC filter and differential amplifier 208 together form a differential amplifier circuit, which is biased to a suitable common-mode voltage (Vcm). The AC coupling renders the circuit sensitive only to high frequency voltage variations on supply rails 102A and 102B. In particular, the differential amplifier circuit is sensitive to the approximate frequency range of di/dt and fast IR drop phenomenon, the detection of which is the scope of the illustrated monitoring circuit. The common-mode voltage Vcm is selected such that the common-mode rejection ratio (CMRR) and the power-supply rejection ratio (PSRR) are maximized. In some embodiments, Vcm can be chosen close to $V_{DD}$.

The differential amplifier circuit depicted in **FIG. 2** features a constant gain over a wide bandwidth. Consequently, the differential amplifier circuit is capable of amplifying measured supply voltage variations on supply rails 102A and 102B according to a known gain, and sending signals corresponding to the measured variations to output pads 108. A signal display device 210 (e.g., an oscilloscope or other display device) connected to output pads 108 can display the amplified signals in an appropriate format (*e.g.,* value displays, graphs of the measured voltage variations over time, *etc.*). Termination resistors 206 can be used to match the impedance of the transmission lines connected to pads 108.

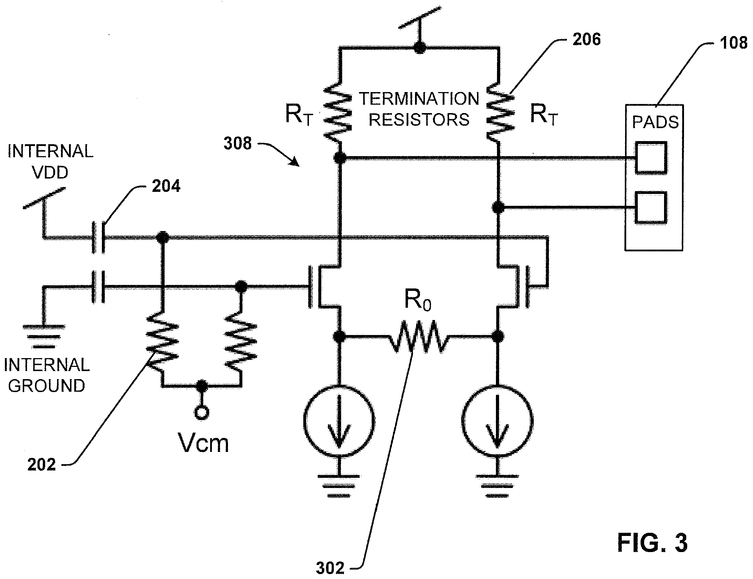

The circuit illustrated in **FIG. 2** illustrates the principal of high frequency power voltage monitor 106. **FIG. 3** illustrates an example implementation of the generalized circuit depicted in **FIG. 2.** In this implementation, a degenerative differential pair circuit 308 represents the constant gain, wide bandwidth differential amplifier 208 of **FIG. 2.** The resistive load $R_T$ of the differential pair also functions as termination resistors 206 for the transmission line connected to pads 108. The common-mode voltage Vcm is chosen close to $V_{DD}$ (the nominal voltage of power supply rail 102A) so that the amplifier has a suitable CMRR and PSRR.

In one or more embodiments, the capacitances 204 can be implemented as fringe-metal capacitances or n-type metal-oxide semiconductor (NMOS) in N-well capacitances. The resistors 202 for biasing the differential pair input pins are selected to be large enough such that the circuit has a wide bandwidth.

The ratio between the termination resistors 206 and the degenerative resistor(s) 302 defines the amplifier gain of the circuit, and is equal to:

$$Gain = \frac{2R_T}{R_{\text{D}}}$$

Because of the limited gain of the amplifier circuit depicted in **FIG. 3**, any offset in the circuit will not cause the amplifier to saturate, thus allowing the circuit to detect the AC variations of the internal supply voltage under a wide range of conditions.

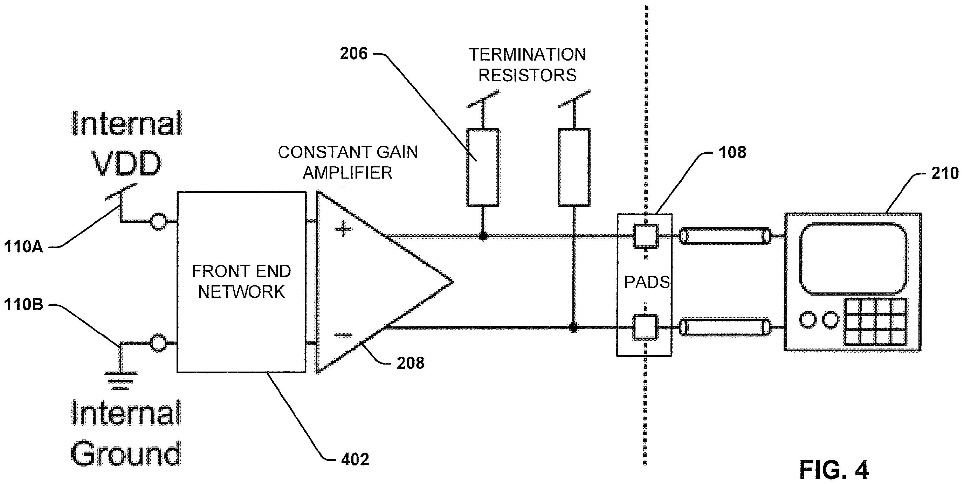

The circuits illustrated in **FIGs. 2** and **3** are designed to be sensitive only to high frequency voltage variations on supply rails 102A and 102B. However, some embodiments of the voltage supply monitor can be configured to monitor both high frequency and low frequency variations on the supply rail. **FIG. 4** illustrates a circuit capable of monitoring both high frequency and low frequency variations. In this example, the high-pass RC filter comprising capacitances 204 and resistors 202 has been replaced with a front-end network 402 capable of passing both high frequency voltage variations as well as low frequency voltage variations (including DC deviations) measured on supply rails 102A and 102B. Similar to the examples described above, the differential amplifier circuit amplifies these detected variations and sends corresponding signals to pads 108, so that the voltage variations can be monitored by a display device 210.

The monitoring circuits depicted in **FIGs. 2-4** are capable of monitoring high frequency variations of a voltage supply substantially in real time. Moreover, the relatively low complexity of the described monitoring circuits eliminates the need for calibration. Also, the monitoring circuits are able to perform high frequency voltage monitoring without the need for sampling systems or analog-to-digital converters.

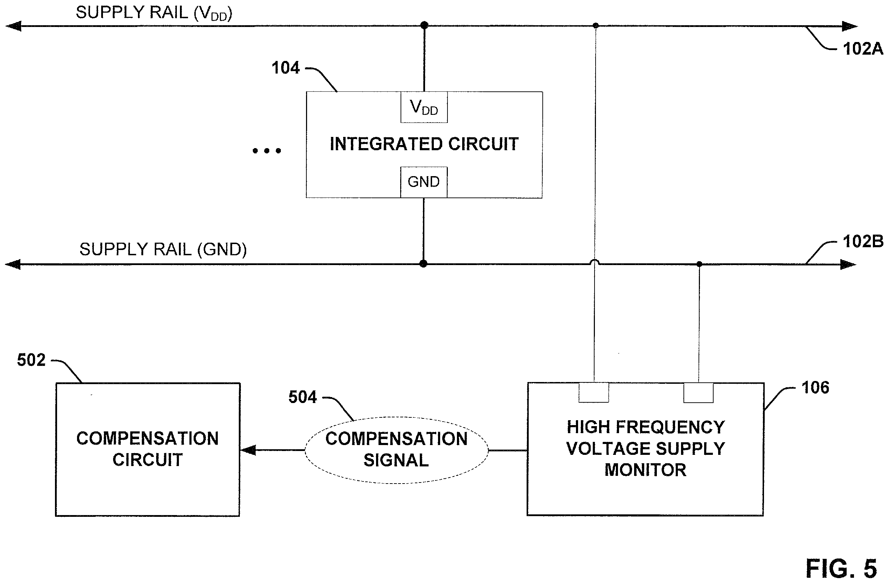

In the examples of **FIGs. 1-4,** the high frequency voltage supply monitor provides the amplified voltage variation measurements to output pads to allow the amplified signals to be visualized on a display device. In other embodiments, the measured output signals may be used internally by the microelectronic system to perform real-time compensation in response to detected voltage variations. **FIG. 5** illustrates a microelectronic system that leverages the measured voltage variations to perform real time circuit compensation and counteract the effects of spikes or oscillations on the supply rails 102A and 102B. In this example, voltage supply monitor 106 monitors and measures high frequency AC noise on supply rails 102A and 102B, as described in previous examples. Based on these measurements, voltage supply monitor 106 delivers a compensation signal 504 to a compensation circuit 502 designed to alter operation of one or more IC components in response to a determination (by either the voltage supply monitor 106 or compensation circuit 502) that the measured voltage variations satisfy a defined criterion.

For example, in response to detection of a high frequency voltage oscillation on voltage supply rails 102A and 102B, the voltage supply monitor 106 may send a compensation signal 504 to compensation circuit 502 reporting the occurrence of AC noise on the supply rails. In response to the compensation signal 504, compensation circuit 502 may curtail, limit, or disable operation of one or more IC components of the microelectronic system in order to reduce the possibility of adverse operation. In an example, compensation circuit 502 may be configured to curtail, limit, or disable operation of specific IC components that are prone to unreliable or unpredictable operation in the presence of high frequency voltage variations on supply rails 102A and 102B. In another example, compensation circuit 502 may be configured to curtail, limit, or disable operation of one or more IC components identified as being noncritical to system operation, thereby reducing the overall system activity rate. Since elevated system activity rates may be a cause of undesired voltage fluctuations, lowering the system activity rate in this manner can at least partially mitigate the high frequency voltage variations as they are detected by the voltage supply monitor 106.

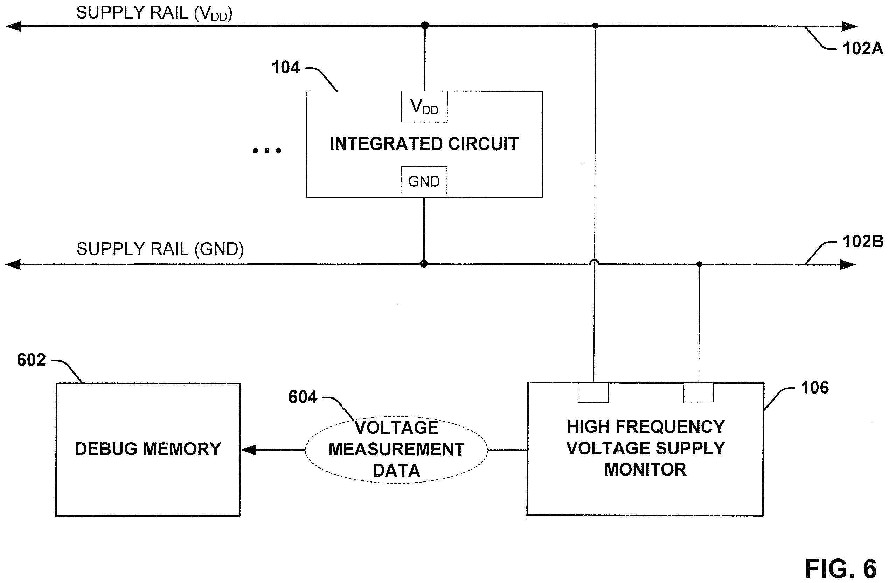

FIG. 6 illustrates an application of voltage supply monitor 106. In this example, voltage measurement data 604 measured by voltage supply monitor 106 is delivered to a local debug memory 602 for storage. In some embodiments, voltage supply monitor 106 may continuously log voltage measurement data 604 to debug memory 602 during operation of the microelectronic system. In other embodiments, voltage supply monitor 106 may record only critical voltage variations detected during operation, where such critical variations are identified by a determination that a measured characteristic of the voltage variations satisfy a defined criterion. For example, voltage supply monitor 106 may be configured to record voltage measurement data 604 to debug memory 602 in response to detecting that a high frequency voltage oscillation exceeds a defined frequency, or has persisted for a defined period of time. Other suitable logging criteria are also within the scope one or more embodiments of this disclosure. Debug memory 602 can subsequently be accessed by an external display device so that the recorded voltage data can be viewed (e.g., during a system debug mode).

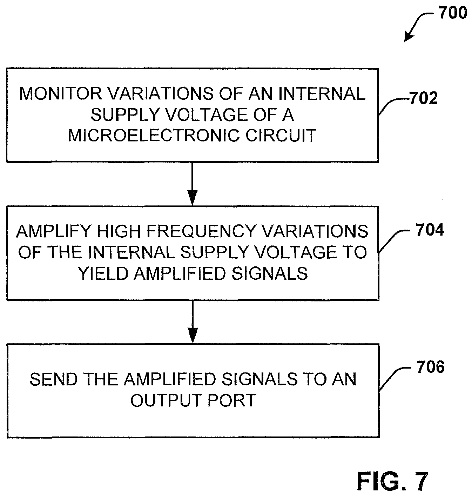

In view of the example systems described above, methods that may be implemented may be better appreciated with reference to the flowcharts of FIGs. 7-9. While for purposes of simplicity of explanation, the methods are shown and described as a series of blocks, it is to be understood and appreciated that the claimed subject matter is not limited by the order of the blocks, as some blocks may occur in different orders and/or concurrently with other blocks from what is depicted and described herein. Moreover, not all illustrated blocks may be required to implement the methods described hereinafter.

FIG. 7 is a flow diagram of an embodiment for monitoring high frequency voltage variations on the supply rails of a microelectronic system. Method 700 can begin at block 702, where variations of an internal supply voltage of a microelectronic circuit are monitored. The supply voltage can be monitored, for example, by a high frequency voltage supply monitor capable of measuring high frequency voltage variations (e.g., high frequency AC noise) on the power supply rails that deliver power to the IC components that make up the microelectronic circuit. At block 704, the measured high frequency variations of the internal supply voltage are amplified. The high frequency variations can be amplified using any suitable circuit, including but not limited to a differential amplifier circuit having a consistent gain over a wide bandwidth. At block 706, the amplified signals are sent to an output port for monitoring and display by an external display device (e.g., an oscilloscope or other display device).

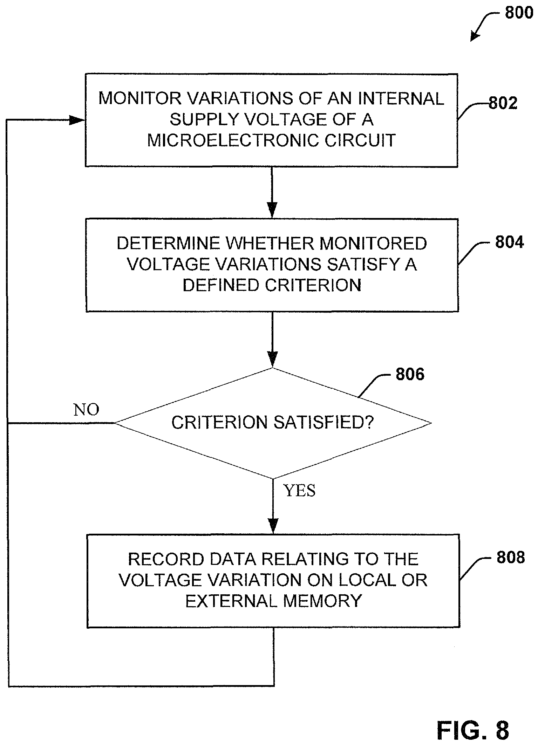

**FIG. 8** is a flow diagram of an embodiment for recording high frequency voltage variations detected on the supply rails of a microelectronic system. Method 800 can begin at block 802, where variations of an internal supply voltage of a microelectronic circuit are monitored; e.g., using a high frequency voltage supply monitor as described in previous examples. At block 804, a determination is made regarding whether the monitored voltage variations satisfy a defined criterion. In an example, the defined criterion may correspond to a determination that a detected voltage variation exceeds a defined frequency, or has persisted for a defined period of time. If it is determined at block 806 that the defined criterion is not satisfied, the methodology returns to block 802 and monitoring continues. Alternatively, if it is determined at block 806 that the defined criterion is satisfied, data relating to the detected voltage variation is recorded on local or external memory at block 808. In some embodiments, the memory can comprise internal debug memory of the microelectronic system, which can be accessed and viewed while the system is placed in a debug mode.

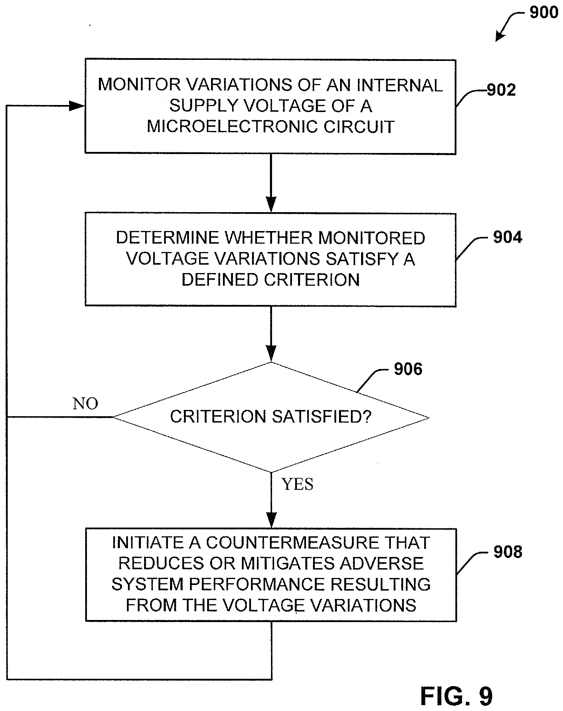

**FIG. 9** is a flow diagram of an embodiment for recording high frequency voltage variations detected on the supply rails of a microelectronic system is shown. Method 900 can begin at block 902, where variations of an internal supply voltage of a microelectronic circuit are monitored; e.g., using a high frequency voltage supply monitor as described in previous examples. At block 904, a determination can be made regarding whether the monitored voltage variations satisfy a defined criterion. In an example, the defined criterion may correspond to a determination that a detected voltage variation exceeds a defined frequency, or has persisted for a defined period of time. If it is determined at block 906 that the defined criterion is not satisfied, the methodology returns to block 902 and monitoring continues. Alternatively, if it is determined at block 906 that the defined criterion is satisfied, a countermeasure is initiated that reduces or mitigates adverse system performance resulting from the detected voltage variations. In an example, the countermeasure can be implemented by a compensation circuit that curtails, limits, or disables operation of one or more IC components of the microelectronic system in response to the determination that the detected variations satisfy the criteria in order to reduce the possibility of adverse or unpredictable operation.

Both a process executed from memory and the processor can be a component. As another example, an architecture can include an arrangement of electronic hardware (e.g., parallel or serial transistors), processing instructions and a processor, which implement the processing instructions in a manner suitable to the arrangement of electronic hardware.

In addition, the disclosed subject matter can be implemented as a method, apparatus, or article of manufacture using typical manufacturing, programming or engineering techniques to produce hardware, firmware, software, or any suitable combination thereof to control an electronic device to implement the disclosed subject matter. Computer-readable media can include hardware media, software media, non-transitory media, or transport media.

## Claims

1. A system for monitoring voltage variations, comprising:

   a differential amplifier circuit comprising a high-pass filter (202, 204) configured to generate a signal in response to detecting a voltage variation that exceeds a defined frequency on a power supply rail (110A) of a microelectronic circuit, the differential amplifier circuit further comprising a differential amplifier (208) configured to receive and amplify the signal to yield an amplified signal representing the voltage variation, wherein said differential amplifier circuit is biased to a common-mode voltage (Vcm) substantially equal to a nominal voltage of the power supply rail (110A), and
   a compensation circuit (502) connected to the differential amplifier circuit and configured to, in response to a determination that the amplified signal satisfies a defined criterion, initiate a countermeasure that modifies a behavior of one or more components of the microelectronic circuit, wherein the countermeasure comprises at least one of disabling, curtailing, or limiting operation of one or more IC components of the microelectronic circuit; wherein
   the high-pass filter (202, 204) comprises at least one capacitor (204) and at least one resistor (202) that couple the power supply rail (110A) to the differential amplifier (208) to yield a differential amplifier circuit; and
   the differential amplifier (208) comprises a degenerative differential pair circuit (308) having a substantially constant gain over a defined bandwidth.

2. The system of claim 1, further comprising:
   a logging component configured to store a record of the amplified signal in a local memory (602) or an external memory.

3. The system of claim 2, wherein said logging component is configured to store said record of the amplified signal in said local memory (602) or said external memory in response to detecting that the voltage variation represented by said amplified signal has persisted for a defined period of time.

**4.** A method for detecting high frequency voltage variations, comprising:

detecting (702), at an input of a high-pass filter (202, 204) of a differential amplifier circuit comprising the high-pass filter (202, 204) and a differential amplifier (208), a voltage variation on a power supply rail (110A) of a microelectronic circuit, wherein said differential amplifier circuit is biased to a common-mode voltage (Vcm) substantially equal to a nominal voltage of the power supply rail (110A);

generating, at an output of the high-pass filter (202, 204), a signal based on the voltage variation;

amplifying (704), by the differential amplifier circuit, the signal to yield an amplified signal representing the voltage variation,

sending (706), by the differential amplifier circuit, the amplified signal to a compensation circuit (502) connected to the differential amplifier circuit; and

in response to a determination (804, 904) that the amplified signal satisfies a defined criterion, initiating (908) by the compensation circuit (502) a countermeasure that modifies a behavior of one or more components of the microelectronic circuit, wherein the countermeasure comprises at least one of disabling, curtailing, or limiting operation of one or more IC components of the microelectronic circuit; wherein the amplifying (704) comprises amplifying the signal using a degenerative differential pair circuit (308) as the differential amplifier (208).

**Patentansprüche**

**1.** System zur Überwachung von Spannungsschwankungen, umfassend:

eine Differenzverstärkerschaltung mit einem Hochpassfilter (202, 204), die derart konfiguriert ist, dass sie als Reaktion auf die Erfassung einer Spannungsänderung, die eine definierte Frequenz auf einer Stromversorgungsschiene (110A) einer mikroelektronischen Schaltung überschreitet, ein Signal erzeugt, wobei die Differenzverstärkerschaltung ferner einen Differenzverstärker (208) umfasst, der so konfiguriert ist, dass er das Signal empfängt und verstärkt, um ein verstärktes Signal zu erzeugen, das die Spannungsänderung darstellt, wobei die Differenzverstärkerschaltung auf eine Gleichtaktspannung (Vcm) vorgespannt ist, die im Wesentlichen gleich einer Nennspannung der Stromversorgungsschiene (110A) ist, und eine Kompensationsschaltung (502), die mit der Differenzverstärkerschaltung verbunden und derart konfiguriert ist, dass sie als Reaktion auf eine Bestimmung, dass das verstärkte Signal ein definiertes Kriterium erfüllt, eine Gegenmaßnahme einleitet, die ein Verhalten von einer oder mehreren Komponenten der mikroelektronischen Schaltung modifiziert, wobei die Gegenmaßnahme mindestens eines der folgenden Elemente umfasst: Deaktivieren, Kürzen oder Begrenzen des Betriebs von einer oder mehreren IC-Komponenten der mikroelektronischen Schaltung; wobei

der Hochpassfilter (202, 204) mindestens einen Kondensator (204) und mindestens einen Widerstand (202) umfasst, die die Stromversorgungsschiene (110A) mit dem Differenzverstärker (208) koppeln, um eine Differenzverstärkerschaltung zu ergeben; und

der Differenzverstärker (208) eine degenerative Differenzpaarschaltung (308) mit einer im Wesentlichen konstanten Verstärkung über eine definierte Bandbreite umfasst.

**2.** System nach Anspruch 1, das ferner umfasst:
eine Aufzeichnungskomponente, die zum Speichern einer Aufzeichnung des verstärkten Signals in einem lokalen Speicher (602) oder einem externen Speicher konfiguriert ist.

**3.** System nach Anspruch 2, wobei die Aufzeichnungskomponente derart konfiguriert ist, dass sie die Aufzeichnung des verstärkten Signals in dem lokalen Speicher (602) oder dem externen Speicher als Reaktion auf die Festellung speichert, dass die durch das verstärkte Signal dargestellte Spannungsänderung für eine definierte Zeitspanne angehalten hat.

**4.** Verfahren zum Erfassen von Hochfrequenz-Spannungsschwankungen, umfassend:

Erfassen (702), an einem Eingang eines Hochpassfilters (202, 204) einer Differenzverstärkerschaltung, die das Hochpassfilter (202, 204) und einen Differenzverstärker (208) umfasst, einer Spannungsänderung auf einer Stromversorgungsschiene (110A) einer mikroelektronischen Schaltung, wobei die Differenzverstärkerschaltung auf eine Gleichtaktspannung (Vcm) vorgespannt ist, die im Wesentlichen gleich einer Nennspannung der Stromversorgungsschiene (110A) ist;

Erzeugen eines auf der Spannungsänderung basierenden Signals an einem Ausgang des Hochpassfilters (202, 204);

Verstärken (704) des Signals durch die Differenzverstärkerschaltung, um ein verstärktes Signal zu ergeben, dass die Spannungsänderung darstellt,

Senden (706) des verstärkten Signals durch die Differenzverstärkerschaltung an eine Kompensationsschaltung (502), die mit der Differenzverstärkerschaltung verbunden ist; und als Reaktion auf eine Bestimmung (804, 904), dass das verstärkte Signal ein definiertes Kriterium erfüllt, Initiieren (908) einer Gegenmaßnahme durch die Kompensationsschaltung (502), die ein Verhalten von einer oder mehreren Komponenten der mikroelektronischen Schaltung modifiziert, wobei die Gegenmaßnahme mindestens eines von Deaktivieren, Kürzen oder Begrenzen des Betriebs von einer oder mehreren IC-Komponenten der mikroelektronischen Schaltung umfasst, wobei das Verstärken (704) das Verstärken des Signals unter Verwendung einer degenerativen Differenzpaarschaltung (308) als Differenzverstärker (208) umfasst.

**Revendications**

1. Système permettant de surveiller des variations de tension, comprenant :

   un circuit d'amplificateur différentiel comprenant un filtre passe-haut (202, 204) configuré pour générer un signal en réponse à la détection d'une variation de tension qui dépasse une fréquence définie sur un rail d'alimentation en énergie (110A) d'un circuit microélectronique, le circuit d'amplificateur différentiel comprenant en outre un amplificateur différentiel (208) configuré pour recevoir et amplifier le signal afin de produire un signal amplifié représentant la variation de tension, ledit circuit d'amplificateur différentiel étant polarisé à une tension de mode commun (Vcm) sensiblement égale à une tension nominale du rail d'alimentation en énergie (110A), et
   un circuit de compensation (502) connecté au circuit d'amplificateur différentiel et configuré pour, en réponse à une détermination selon laquelle le signal amplifié satisfait à un critère défini, lancer une contre-mesure qui modifie un comportement d'un ou de plusieurs composants du circuit microélectronique, la contre-mesure comprenant la désactivation, et/ou la réduction, et/ou la limitation du fonctionnement d'un ou de plusieurs composants de circuit intégré du circuit microélectronique ;
   le filtre passe-haut (202, 204) comprenant au moins un condensateur (204) et au moins une résistance (202) qui couplent le rail d'alimentation en énergie (110A) à l'amplificateur différentiel (208) pour produire un circuit d'amplificateur différentiel ; et

   l'amplificateur différentiel (208) comprenant un circuit à paires différentielles dégénératif (308) ayant un gain sensiblement constant sur une largeur de bande définie.

2. Système selon la revendication 1, comprenant en outre :
   un composant d'enregistrement configuré pour stocker un enregistrement du signal amplifié dans une mémoire locale (602) ou une mémoire externe.

3. Système selon la revendication 2, dans lequel ledit composant d'enregistrement est configuré pour stocker ledit enregistrement du signal amplifié dans ladite mémoire locale (602) ou ladite mémoire externe en réponse à la détection du fait que la variation de tension représentée par ledit signal amplifié a persisté pendant une période de temps définie.

4. Procédé permettant la détection de variations de tension haute fréquence, comprenant :

   la détection (702), au niveau d'une entrée d'un filtre passe-haut (202, 204) d'un circuit d'amplificateur différentiel comprenant le filtre passe-haut (202, 204) et un amplificateur différentiel (208), d'une variation de tension sur un rail d'alimentation en énergie (110A) d'un circuit microélectronique, ledit circuit d'amplificateur différentiel étant polarisé à une tension de mode commun (Vcm) sensiblement égale à une tension nominale du rail d'alimentation en énergie (110A) ;
   la génération, au niveau d'une sortie du filtre passe-haut (202, 204), d'un signal sur la base de la variation de tension ;
   l'amplification (704), par le circuit d'amplificateur différentiel, du signal pour produire un signal amplifié représentant la variation de tension,
   l'envoi (706), par le circuit d'amplificateur différentiel, du signal amplifié à un circuit de compensation (502) connecté au circuit d'amplificateur différentiel ; et
   en réponse à une détermination (804, 904) selon laquelle le signal amplifié satisfait à un critère défini, le lancement (908) par le circuit de compensation (502) d'une contre-mesure qui modifie un comportement d'un ou de plusieurs composants du circuit microélectronique, la contre-mesure comprenant la désactivation, et/ou la réduction, et/ou la limitation du fonctionnement d'un ou de plusieurs composants de circuit intégré du circuit microélectronique ; l'amplification (704) comprenant l'amplification du signal à l'aide d'un circuit à paires différentielles dégénératif (308) comme amplificateur différentiel (208).

EP 3 329 287 B1

INTERNAL CIRCUIT

**FIG. 1**

FIG. 2

EP 3 329 287 B1

FIG. 3

EP 3 329 287 B1

Internal VDD

110A

110B

Internal Ground

FRONT END NETWORK

CONSTANT GAIN AMPLIFIER

+

−

402

208

206

TERMINATION RESISTORS

108

PADS

210

FIG. 4

EP 3 329 287 B1

SUPPLY RAIL ($V_{DD}$)

102A

104

$V_{DD}$

INTEGRATED CIRCUIT

• • •

GND

SUPPLY RAIL (GND)

102B

502

504

COMPENSATION CIRCUIT

COMPENSATION SIGNAL

HIGH FREQUENCY VOLTAGE SUPPLY MONITOR

106

FIG. 5

FIG. 6

700

MONITOR VARIATIONS OF AN INTERNAL
SUPPLY VOLTAGE OF A
MICROELECTRONIC CIRCUIT — 702

AMPLIFY HIGH FREQUENCY VARIATIONS
OF THE INTERNAL SUPPLY VOLTAGE TO — 704
YIELD AMPLIFIED SIGNALS

SEND THE AMPLIFIED SIGNALS TO AN
OUTPUT PORT — 706

**FIG. 7**

800

MONITOR VARIATIONS OF AN INTERNAL SUPPLY VOLTAGE OF A MICROELECTRONIC CIRCUIT — 802

DETERMINE WHETHER MONITORED VOLTAGE VARIATIONS SATISFY A DEFINED CRITERION — 804

CRITERION SATISFIED? — 806

NO

YES

RECORD DATA RELATING TO THE VOLTAGE VARIATION ON LOCAL OR EXTERNAL MEMORY — 808

**FIG. 8**

900

MONITOR VARIATIONS OF AN INTERNAL
SUPPLY VOLTAGE OF A
MICROELECTRONIC CIRCUIT ⟩902

DETERMINE WHETHER MONITORED
VOLTAGE VARIATIONS SATISFY A
DEFINED CRITERION ⟩904

906

NO ⟨ CRITERION SATISFIED? ⟩

YES

INITIATE A COUNTERMEASURE THAT
REDUCES OR MITIGATES ADVERSE
SYSTEM PERFORMANCE RESULTING
FROM THE VOLTAGE VARIATIONS ⟩908

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010085110 A1